**Europäisches Patentamt**

**European Patent Office**

**Office européen des brevets**

(19)

(11) Numéro de publication: **0 003 450**

**B1**

(12) **FASCICULE DE BREVET EUROPEEN**

(45) Date de publication du fascicule de brevet: **12.08.81**

(51) Int. Cl.³: **G 01 R 21/01, H 04 B 1/04**

(21) Numéro de dépôt: **79400022.4**

(22) Date de dépôt: **11.01.79**

(54) **Dispositif de mesure en hyperfréquence et générateur comportant un tel dispositif.**

(30) Priorité: **20.01.78 FR 7801635**

(43) Date de publication de la demande:
**08.08.79 Bulletin 79/16**

(45) Mention de la délivrance du brevet:
**12.08.81 Bulletin 81/32**

(84) Etats Contractants Désignés:
**DE GB IT**

(56) Documents cités:
**DE - C - 920 973**

(73) Titulaire: **THOMSON-CSF**
**173, Boulevard Haussmann**
**F-75360 Paris Cedex 08 (FR)**

(72) Inventeur: **Legendre, Philippe**
**"THOMSON-CSF" - SCPI 173, bld Haussmann**
**F-75360 Paris Cedex 08 (FR)**
Inventeur: **Van Keerebroeck, Claude**
**"THOMSON-CSF" -SCPI 173, bld Haussmann**
**F-75360 Paris Cedex 08 (FR)**

(74) Mandataire: **Blaise, Michel et al.**
**"THOMSON-CSF" 173, bld Haussmann**
**F-75360 Paris Cedex 08 (FR)**

Courier Press, Leamington Spa, England.

Dispositif de mesure en hyperfréquence et générateur comportant un tel dispositif

La présente invention concerne les dispositifs de mesure en hyperfréquence, et en particulier les dispositifs permettant de réaliser un prélèvement d'énergie en dérivation sur un point donné d'une ligne de transmission adaptée, afin de déterminer la puissance transmise par la ligne et d'effectuer la mesure des caractéristiques du signal correspondant, à l'aide d'un accès de mesure d'impédance normalisée.

Il est connu, par exemple par le brevet allemand 209 973, de mesurer la puissance transmise dans un circuit, en bout de ligne, par l'intermédiaire d'un diviseur de puissance. Un tel circuit introduit des pertes.

Pour déterminer la puissance transmise sur une ligne et effectuer en même temps des mesures sur le signal transmis, une solution possible consiste à réaliser une branche de dérivation sur la ligne comportant deux coupleurs directionnels en cascade, afin de rendre ces deux fonctions indépendantes l'une de l'autre, mais une telle réalisation est coûteuse et délicate, en particulier aux fréquences supérieures à 4 GHz.

L'invention a pour objet un dispositif de mesure en hyperfréquence qui n'introduit que des pertes faibles sur la ligne principale de transmission hyperfréquence adaptée d'impédes deux fonctions requises, et réalise ces deux fonctions à l'aide d'un circuit unique non directionnel.

Selon l'invention, le dispositif de mesure comportant des moyens de prélèvement d'énergie en un point donné d'une ligne de transmission hyperfréquence adaptée d'impédance caractéristique $Z_o$ est caractérisé en ce qu'il comporte un premier tronçon de ligne d'impédance caractéristique $Z_2$ dont une des extrémités est connectée à ce point donné, et un deuxième tronçon de ligne d'impédance caractéristique $Z_1$, avec $(Z_1)^2 \ll (Z_2)^2$, connecté en série avec le premier tronçon et dont l'extrémité libre est connectée à un circuit d'utilisation, la longueur électrique des premier et second tronçons étant identique et égale au quart de la longueur d'onde du signal central du spectre de signaux alimentant la ligne de transmission.

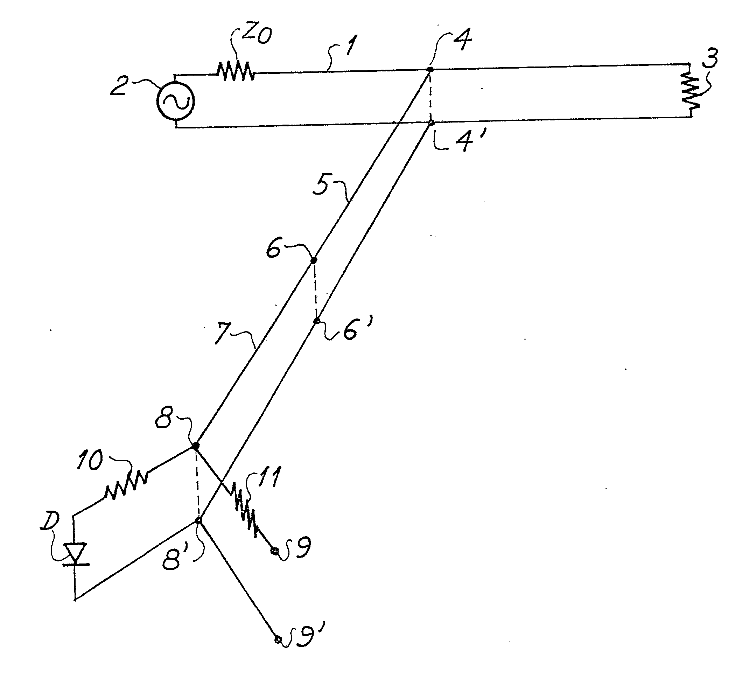

L'invention sera mieux comprise et d'autres caractéristiques apparaîtront à l'aide de la description ci-après et du dessin s'y rapportant qui représente le schéma d'un dispositif de mesure selon l'invention.

Sur la figure, une ligne bifilaire 1 d'impédance caractéristique $Z_o$ est alimentée à une extrémité par un générateur 2 d'impédance interne $Z_o$ et fermée à l'autre extrémité par une résistance 3 d'impédance égale à $Z_o$.

En un point 4—4' de cette ligne est raccordé en dérivation un tronçon de ligne 5 d'impédance caractéristique $Z_2$ se raccordant par son extrémité 6—6' à un deuxième tronçon de ligne

7 d'impédance caractéristique $Z_1$, et dont les extrémités 8—8' sont raccordées d'une part à une diode D d'impédance $Z_D$ en série avec une résistance 10 d'impédance $Z_R$ et d'autre part à des bornes 9—9' à travers une résistance 11.

La diode D et la résistance 10 schématisent un système détecteur permettant, en particulier, d'obtenir une tension représentative de la puissance transmise le long de la ligne 1. Les bornes 9—9' représentent un accès pour le raccordement d'appareils de mesure.

Soit $\lambda$ la longueur d'onde du signal correspondant à la fréquence centrale du spectre de fréquence transmis par la ligne.

Les tronçons de ligne 5 et 7 ont une longueur électrique identique et égale à $\lambda/4$.

L'impédance $Z_{4-4'}$, entre les points 4—4', est égale à

$$\frac{Z_o}{2}$$

qui correspond à la mise en parallèle des impédances de source et de charge de la ligne, identiques entre elles et à l'impédance caractéristique $Z_o$.

Elle est transformée par le tronçon de ligne 5 pour être vue en 6—6' sous forme d'une impédance $Z_{6-6'}$, telle que

$$Z_{6-6'} = \frac{Z_2^2}{Z_{4-4'}}$$

$$\text{soit } Z_{6-6'} = \frac{2Z_2^2}{Z_o} .$$

De même, au point d'extrémité du bras dérivé 8—8' l'impédance vue est

$$Z_{8-8'} = \frac{Z_1^2}{Z_{6-6'}}$$

$$\text{soit } Z_{8-8'} = \frac{Z_o}{2} \frac{Z_1^2}{Z_2^2} .$$

Sous condition d'astreindre les valeurs de $Z_1$ et $Z_2$ à l'inégalité $Z_1^2 \ll Z_2^2$, $Z_{8-8'}$ sera donc très inférieure à $Z_o$.

Dans la mesure où l'impédance de charge $Z_C$ de l'ensemble du circuit d'utilisation raccordée aux bornes 8—8', et donc ramenée en parallèle sur $Z_{8-8'}$, est du même ordre que $Z_o$, $Z_C$ est très supérieure à $Z_{8-8'}$; son effet sera négligeable devant $Z_{8-8'}$, et les deux branches du circuit d'utilisation seront indépendantes.

Un calcul analogue à celui établi pour $Z_{8-8'}$ donne pour l'impédance $Z'_{4-4'}$ résultant de la

transformation de $Z_C$ par les tronçons de ligne 7, puis 5, la valeur

$$Z'_{4-4'} = Z_C \frac{Z_2^2}{Z_1^2}$$

A titre d'exemple, supposons qu'il soit désiré une puissance $P_M$, aux bornes 9—9', de 20dB inférieure à celle, $P_E$, transmise sur la ligne 1 au point 4—4', et que les appareils de mesure dont le raccordement est prévu aux bornes 9—9' présentent une impédance d'entrée normalisée égale à l'impédance caractéristique de la ligne $Z_o$.

Cette dernière hypothèse implique que les appareils soient alors adaptés à la source en donnent la valeur $Z_o$ à la résistance 11 (à cause de la valeur négligeable de $Z_{8-8'}$), et, en choisissant la valeur de l'impédance $Z_R$ telle que $Z_R + Z_D = 2Z_o$, on aura alors $Z_c = Z_o$. Au cas extrême où les bornes 9—9' seraient non raccordées ou en court-circuit, la valeur de $Z_c$ passerait ainsi respectivement à $2Z_o$ ou à

$$\frac{2Z_o}{3}.$$

Dans ces conditions, des calculs simples montrent que pour $Z_c = Z_o$, on peut écrire:

$$\frac{P_M}{P_E} = \frac{1}{4\left(\dfrac{Z_2^2}{Z_1^2} + 1\right)}.$$

Avec l'hypothèse faite de

$$10 \log \frac{P_M}{P_E} = 20dB$$

on obtient:

(1) $$\frac{Z_2}{Z_1} = 4,9$$

ce qui satisfait bien la condition $Z_2^2 \ll Z_1^2$; (qui l'est d'ailleurs d'autant mieux que la valeur choisie pour le rapport

$$\frac{P_M}{P_E}$$

est plus faible).

De la quantité infinie de couples possibles de valeurs $Z_1$, $Z_2$ pouvant satisfaire à la condition (1), il a été choisi en exemple $Z_2 = 78$ ohms d'où $Z_1 = 16$ ohms, valeurs indépendantes de celle de $Z_o$, elle-même choisie égale à 50 ohms.

Un calcul simple montre, qu'à la fréquence centrale, la puissance appliquée à la diode, $P_D$, rapportée à la puissance $P_E$ transmise sur la ligne 1 est donnée par

$$\frac{P_D}{P_E} = \frac{Z_D \; Z_C}{4Z_0\left(Z_C \dfrac{Z_2^2}{Z_1^2} + Z_0\right)}$$

$P_D$ est évidemment égale à $P_M$ si $Z_D = Z_o$ et $Z_c = Z_o$.

Le calcul montre également que les variations d'adaptation maximales de l'accès 9—9' (ouvert ou en court-circuit), entraînent, sur la ligne principale, une perte de transmission maximale de 0,3dB, et une valeur de l'affaiblissement d'adaptation minimale égale à —30dB (cas du court-circuit).

Enfin, des variations de 30% en plus ou en moins par rapport à la fréquence centrale entraînent une remontée maximale de 2dB de la puissance de transmission à l'accès de mesure 9—9' où l'affaiblissement d'adaptation reste au moins égal à —20dB.

Quand à la variation de la puissance appliquée sur le détecteur, elle reste inférieure à 0,15dB, toutes causes confondues de variations de fréquence ($\pm$ 30%) ou d'adaptation de l'accès de mesure.

Il sera noté que les intéressantes performances de ce dispositif peuvent être obtenues dans n'importe quel mode de propagation et quelque soit l'impédance caractéristique.

Le mode de réalisation, présenté sur la figure par des lignes bifilaires pour la commodité du dessin, peut être, en pratique, une des nombreuses formes plus appropriées aux hyperfréquences, en particulier les lignes coaxiales.

De tels dispositifs sont destinés à des générateurs radioélectriques, en particulieur des gnérateurs d'oscillation locale ou des émetteurs dont ils équipent les lignes de sortie munies, en aval, d'isolateur et/ou de charge adaptée.

## Revendications

1. Dispositif de mesure comportant des moyens de prélèvement d'énergie en un point donné (4, 4') d'une ligne de transmission hyperfréquence (1) adaptée d'impédance caractéristique $Z_o$, caractérisé en ce qu'il comporte un premier tronçon de ligne (5) d'impédance caractéristique $Z_2$ dont une des extrémités est connectée à ce point (4, 4') donné, et un deuxième tronçon de ligne (7) d'impédance caractéristique $Z_1$, avec $(Z_1)^2 \ll (Z_2)^2$, connecté en série avec le premier tronçon et dont l'extrémité libre (8, 8') est connectée à un circuit d'utilisation, la longueur électrique des premier et second tronçons étant identique et égale au quart de la longueur d'onde du signal central du spectre de signaux alimentant la ligne de transmission (9).

2. Dispositif de mesure selon la revendication 1, caractérisé en ce que le circuit d'utilisation comporte des moyens de détection (D, 10) constitués d'une résistance $Z_R$ en série avec une impédance $Z_D$, telles que

$$Z_R + Z_D \gg \frac{Z_o}{2} \frac{Z_1^2}{Z_2^2}.$$

3. Dispositif de mesure selon la revendication 2, caractérisé en ce que le circuit d'utilisation comporte en outre un accès de mesure (9, 9') couplé en parallèle avec les moyens de détection.

4. Dispositif de mesure selon la revendication 3, caractérisé en ce que l'accès de mesure est couplé aux moyens de détection à travers une impédance $Z_o$, la valeur de $Z_R$ étant choisie telle que $Z_R + Z_D = 2Z_o$.

5. Générateur hyperfréquence caractérisé en ce qu'il comporte au moins un dispositif de mesure selon l'une des revendications 1 à 3.

## Claims

1. Measuring device including means for extracting energy at a given point (4, 4') of an adapted hyperfrequency transmission line (1) of the characteristic impedance $Z_o$, characterized in that it comprises a first line section (5) of the characteristic impedance $Z_2$ one end of which is connected to this given point (4, 4'), and a second line section (7) of characteristic impedance $Z_1$, with $(Z_1)^2 \ll (Z_2)^2$, series-connected with the first section, and having one free end (8, 8') connected to a load circuit, the electrical length of the first and second sections being identical and equal to a forth of the wave length of the central signal of the signal spectrum feeding the transmission line (1).

2. Measuring device of claim 1, characterized in that the load circuit comprises detection means (D, 10) formed by a resistor $Z_R$ is series with an impedance $(Z_D)$, which are such that

$$Z_R + Z_D \gg \frac{Z_o}{2} \frac{Z_1^2}{Z_2^2}.$$

3. Measuring device of claim 2, characterized in that the load circuit further comprises a measuring terminal (9, 9') coupled in parallel with the detection means.

4. Measuring device of claim 3, characterized in that the measuring terminal is connected to the detection means through an impedance $Z_o$, the value of $Z_R$ being selected such that $Z_R + Z_D = 2Z_o$.

5. Hyperfrequency generator, characterized in that it comprises at least one measuring device in accordance with any of claims 1 through 3.

## Patentansprüche

1. Meßvorrichtung mit Mitteln zur Abnahme von Energie an einem gegebenen Punkt (4, 4') einer angepaßten Höchstfrequenz-Übertragungsleitung (1) mit dem Wellenwiderstand $Z_o$, dadurch gekennzeichnet, daß sie einen ersten Leitungsabschnitt (5) mit dem Wellenwiderstand $(Z_2)$ umfaßt, woven ein Ende mit diesem gegebenen Punkt (4, 4') verbunden ist, und einen zweiten Leitungsabschnitt (7) umfaßt, dessen Wellenwiderstand $Z_1$ ist, mit $(Z_1)^2 \ll (Z_2)^2$, wobei der zweite mit dem ersten Abschnitt in Reihe geschaltet ist und sein freies Ende (8, 8') mit einer Verbraucherschaltung verbunden ist und wobei die elektrische Länge des ersten und des zweiten Abschnitts jeweils dieselbe ist und gleich dem Viertel der Wellenlänge des Mittensignals des Sprektrums der die Übertragungsleitung (1) speisenden Signale ist.

2. Meßvorrichtung nach Anspruch 1, dadurch gekennzeichnet, daß die Verbraucherschaltung Detektionsmittel (D, 10) umfaßt, die aus einem Widerstand $Z_R$ in Reihe mit einer Impedanz $Z_D$ gebildet sind, welche so ausgebildet sind, daß:

$$Z_R + Z_D \gg \frac{Z_o}{2} \frac{Z_1^2}{Z_2^2}.$$

3. Meßvorrichtung nach Anspruch 2, dadurch gekennzeichnet, daß die Verbraucherschaltung ferner einen Meßanschluß (9, 9') umfaßt, der parallel zu den Detektionsmitteln geschaltet ist.

4. Meßvorrichtung nach Anspruch 3, dadurch gekennzeichnet, daß der Meßanschluß an die Detektionsmittel über eine Impedanz $(Z_o)$ angekoppelt ist, wobei der Wert von $Z_R$ so gewählt ist, daß $Z_R + Z_D = 2Z_o$.

5. Höchstfrequenzgenerator, dadurch gekennzeichnet, daß er wenigstens eine Meßvorrichtung nach einem der Ansprüche 1 bis 3 umfaßt.